# FASCICULE DE BREVET EUROPEEN

(11) **EP 1 320 919 B1**
(45) Date de publication et mention de la délivrance du brevet: **18.01.2006**
(21) Numéro de dépôt: 00966217.2
(22) Date de dépôt: 28.09.2000
(51) Int. Cl.: H02M 3/335

(54) **LIMITATION DU MODE CONTINU D'UN CONVERTISSEUR DE PUISSANCE**
DAUERBETRIEBSBEGRENZUNG IN EINEM SCHALTNETZTEIL
LIMITING THE CONTINUOUS MODE OF A POWER CONVERTER

(43) Date de publication de la demande: 25.06.2003
(73) Titulaire: STMicroelectronics SA, 94250 Gentilly Cedex (FR)
(72) Inventeur: BAILLY, Alain, F-13790 Rousset (FR); BARRET, Jean, F-13510 Eguilles (FR)
(74) Mandataire: de Beaumont, Michel
(86) Numéro de dépôt international: PCT/FR2000/002684
(87) Numéro de publication internationale: WO 2002/027906

(56) Documents cités:
- EP-A- 0 529 366
- EP-A- 0 991 170
- US-A- 5 757 214
- US-A- 5 757 625

## Description

La présente invention concerne le domaine des convertisseurs de puissance du type alimentation à découpage basse tension. L'invention s'applique plus particulièrement aux alimentations isolées, c'est-à-dire ne disposant pas de point commun entre la tension d'entrée (par exemple, le réseau d'alimentation alternative) et la tension continue régulée de sortie. L'isolement est obtenu au moyen d'un transformateur dont un enroulement primaire est associé à un commutateur commandé en modulation de largeur d'impulsions, et dont un enroulement secondaire est associé à une diode et à un condensateur fournissant la tension de sortie.

Le document EP-A-0 529 366 décrit un circuit de commande d'un interrupteur de découpage d'une tension d'alimentation fournie au primaire d'un transformateur. Ce circuit comporte une résistance pour mesurer le courant dans l'interrupteur de découpage, et un comparateur par rapport à un seuil. La sortie du comparateur est prise en compte avec retard par rapport aux commandes en ouverture/fermeture de l'interrupteur à découpage au moyen d'un transistor MOS dont la grille reçoit le signal de commande de l'interrupteur après traversée d'un circuit RC.

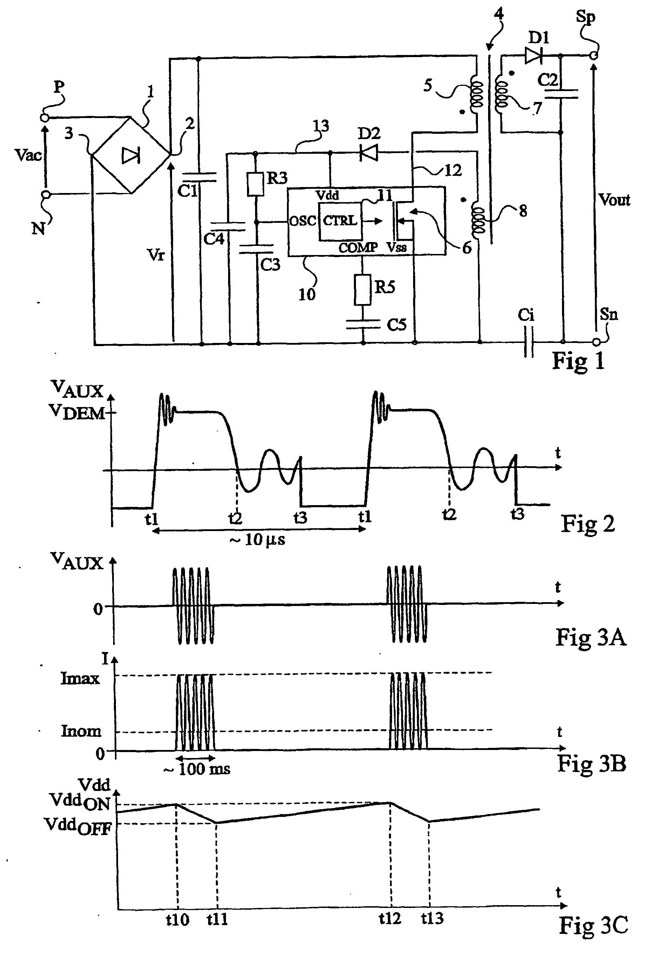

La figure 1 représente un exemple classique d'alimentation à découpage du type auquel s'applique la présente invention. Deux bornes P, N d'entrée reçoivent une tension alternative Vac, par exemple, la tension du secteur. Cette tension Vac fait l'objet d'un redressement, par exemple un redressement double alternance au moyen d'un pont 1 de diodes. Les bornes d'entrée alternative du pont 1 sont reliées aux bornes P et N, et ses bornes 2, 3 de sortie redressée fournissent une tension Vr. La tension Vr est généralement lissée au moyen d'un condensateur C1 connecté entre les bornes 2 et 3 qui constituent les bornes d'entrée de l'alimentation à découpage proprement dite.

Le convertisseur de la figure 1 constitue un convertisseur connu sous le nom "flyback" dans lequel un transformateur 4 à points de phase inversés a son enroulement primaire 5 connecté en série avec un interrupteur 6 entre les bornes 2 et 3. Le point de phase de l'enroulement 5 est relié à une borne du commutateur 6 dont l'autre borne est connectée à la borne 3. L'interrupteur 6 est commandé en mode à découpage et à fréquence élevée non audible (généralement, supérieure à 20 kHz). Un enroulement secondaire 7 du transformateur 4 est associé à un condensateur C2 aux bornes Sp et Sn duquel est fournie la tension de sortie continue Vout. Le point de phase de l'enroulement 7 est connecté à la borne Sp par une diode D1, la cathode de la diode D1 étant connectée à la borne Sp. L'autre borne de l'enroulement 7 est reliée à la borne Sn. Les bornes de masse 3 et Sn sont isolées l'une de l'autre au moyen d'un condensateur Ci.

Quand l'interrupteur 6 est fermé, le point de phase de l'enroulement 7 est à un potentiel négatif. La diode D1 est donc bloquée et un courant est accumulé dans l'enroulement primaire 5. A l'ouverture du commutateur 6, les points de phase des enroulements 5 et 7 deviennent tous deux positifs. La diode D1 est polarisée en direct. Le condensateur C2 est alors chargé avec l'énergie transférée à l'enroulement secondaire 7.

Le commutateur 6 (par exemple, un transistor MOS) est, dans l'exemple de la figure 1, intégré dans un circuit 10 avec son circuit électronique de commande. Un exemple d'un tel circuit intégré, commercialisé par la société STMicroelectronics, est connu sous la dénomination commerciale VIPER. Le circuit VIPER comporte une borne d'entrée Vdd destinée à recevoir une alimentation positive, une borne de référence de tension Vss reliée à la masse 3, et une borne OSC conditionnant une fréquence d'oscillation. Le circuit 10 comprend en outre une borne COMP de compensation de la boucle de régulation, reliée par une résistance R5 en série avec un condensateur C5, à la masse 3. Enfin, une borne 12 est reliée au drain du transistor à canal N intégré, dont la source est reliée à la borne Vss. La grille du transistor 6 est connectée en sortie d'un circuit 11 (CTRL) de commande. Ce circuit 11 comprend un comparateur (non représenté) dont une première entrée reçoit une référence de tension interne et dont une deuxième entrée est connectée, en interne, à la borne d'alimentation positive. L'asservissement, c'est-à-dire la modification de largeur d'impulsions de commande de l'interrupteur 6, s'effectue par exemple en utilisant une boucle de régulation du circuit intégré 10 qui cherche à maintenir sa tension d'alimentation (Vdd-Vss). Ce type de régulation s'effectue côté primaire du transformateur. On peut également réguler la tension de sortie à partir d'une mesure côté secondaire, ramenée au circuit 10 par un élément d'isolement galvanique (par exemple, un optocoupleur). La borne OSC est reliée au point milieu d'une association en série d'une résistance R3 et d'un condensateur C3 entre une ligne 13 d'alimentation locale du circuit 10 et la masse. La résistance R3 et le condensateur C3 fixent la fréquence d'oscillation. Un condensateur C4 de filtrage de la tension d'alimentation locale est connecté entre la borne 13 et la borne 3.

Un problème qui se pose dans les convertisseurs de type flyback est que, lorsqu'un court-circuit se produit en sortie du convertisseur de puissance, la diode D1 et le transformateur 4 ne sont pas protégés. Ils risquent donc d'être endommagés sous l'effet du fort courant qui traverse le transformateur. De plus, une fusion du transformateur rompt l'isolement galvanique, ce qui est particulièrement dangereux si le convertisseur de puissance est alimenté par le secteur. Des normes fixent généralement la durée de tenue en court-circuit d'un convertisseur de puissance de ce type.

Dans une application à un convertisseur à découpage, la ligne 13 d'alimentation locale du circuit 10 est souvent connectée, comme l'illustre la figure 1, par une diode D2, au point de phase d'un enroulement auxiliaire 8 du transformateur 4. Dans ce cas, l'autre borne de l'enroulement auxiliaire 8 est connectée à la borne 3 de référence de la tension redressée. L'enroulement auxiliaire 8 a pour rôle de fournir la tension d'alimentation Vdd du circuit 10. La tension de sortie est alors fixée par le rapport de transformation entre les enroulements auxiliaire 8 et secondaire 7. On utilise l'enroulement auxiliaire 8 qui donne une image de la tension de sortie, celui-ci étant en relation de phase directe avec l'enroulement secondaire 7.

Dans un tel montage, on peut prévoir un détecteur de courant (non représenté) en série avec l'interrupteur 6. Le résultat de la détection est alors fourni à un comparateur qui, au moyen de circuits logiques adaptés, ouvre l'interrupteur 6 quand le courant dépasse un seuil. On réduit ainsi la quantité d'énergie transmise au secondaire. De plus, comme l'enroulement auxiliaire 8 est en relation de phase directe avec l'enroulement secondaire 7, la chute de tension qui apparaît aux bornes de l'enroulement secondaire est, au bout d'un temps dépendant de la valeur du condensateur C4, vue par la ligne d'alimentation du circuit 10. L'alimentation du circuit 10 devient insuffisante pour son fonctionnement, ce qui garantit l'ouverture de l'interrupteur 6.

Les figures 2, 3A, 3B et 3C illustrent le fonctionnement d'un tel convertisseur de puissance en régime normal et en court-circuit au secondaire. La figure 2 illustre un exemple de l'allure de la tension v_{AUX} aux bornes de l'enroulement auxiliaire 8 en fonctionnement normal. Les figures 3A, 3B et 3C représentent, respectivement, l'allure de la tension V_{AUX}, du courant I dans l'interrupteur 6 et de la tension Vdd d'alimentation locale du circuit 10 lorsque le secondaire du transformateur est en court-circuit.

En fonctionnement normal, à chaque ouverture (instants t1) de l'interrupteur 6, la tension V_{AUX} croît brusquement depuis une valeur négative jusqu'à une valeur V_{DEM} de démagnétisation. La valeur V_{DEM} n'est atteinte qu'après quelques oscillations parasites liées à l'ouverture de l'interrupteur 6. Une fois la démagnétisation complète, la tension V_{AUX} chute (instants t2) et présente des oscillations centrées sur le zéro de tension jusqu'à la fermeture (instants t3) de l'interrupteur 6 où la tension V_{AUX} redevient négative. La même forme d'ondes est obtenue aux bornes de l'enroulement secondaire 7, avant que la tension soit filtrée par le condensateur C2.

Lorsqu'un court-circuit est présent entre les bornes Sp et Sn (figures 3A à 3C), on limite le courant dans l'interrupteur 6 à une valeur Imax (instants t10 à t11) par le circuit de détection décrit précédemment. On assiste alors à une diminution progressive de la tension Vdd d'alimentation du circuit 10 (figure 3C). Cette diminution progressive atteint un seuil (Vdd_{OFF}) en deçà duquel le circuit 10 ne reçoit plus l'alimentation suffisante. A partir de cet instant t11, l'interrupteur 6 reste ouvert et aucun courant n'est transmis au secondaire. Toutefois, cela remet en route le circuit de démarrage généralement associé au convertisseur de puissance. Ce redémarrage provoque une augmentation progressive de la tension Vdd d'alimentation locale. Quand cette tension atteint (instant t12) le seuil (Vdd_{ON}) de fonctionnement du circuit 10, on assiste de nouveau à des appels de courants élevés (instants t12 à t13). La tension V_{AUX} (figure 3A) présente des oscillations à chaque pic de courant.

L'échelle est différente entre les figures 2 et les figures 3A à 3C. En figure 2, on a représenté la période de découpage (de l'ordre de 10 microsecondes) de la tension d'alimentation. Aux figures 3A à 3C, on a représenté l'intervalle de temps séparant les instants t10 et t11 pendant lesquels la décroissance de la tension d'alimentation locale Vdd prend plusieurs cycles de découpage et dure, par exemple, environ 100 millisecondes.

Pour respecter les normes, on prévoit généralement un rapport cyclique qui permette aux transformateurs de supporter les courants importants Imax (figure 3B) qui, mêmes limités, sont fortement supérieurs au courant nominal Inom de fonctionnement normal du convertisseur. Par exemple, pour un courant nominal de 2 ampères, le courant de limitation est de l'ordre de 10 ampères.

Un problème qui subsiste dans cette solution classique est que le transformateur 4 est quand même sollicité à sa puissance maximale. Par conséquent, l'enroulement auxiliaire génère des perturbations parasites (figure 3A). Ces parasites sont également présents en régime normal mais leur amplitude est plus importante en court-circuit du secondaire. Par conséquent, bien que la tension auxiliaire chute, on a souvent des amplitudes suffisantes pour une alimentation autonome du circuit de commande.

Un autre problème est lié à la durée minimale de conduction de l'interrupteur 6. En effet, il faut que l'on puisse ouvrir l'interrupteur 6 suffisamment rapidement après chaque fermeture, faute de quoi, on ne parvient pas à démagnétiser sous la faible tension d'alimentation locale du circuit auxiliaire, et le courant n'est alors plus contrôlé.

La présente invention vise à proposer un convertisseur de puissance de type alimentation à découpage isolée qui pallie les inconvénients des convertisseurs connus et, plus particulièrement, qui supporte une mise en court-circuit de ses bornes de sortie.

Une première solution serait de conditionner le redémarrage du circuit de commande de l'interrupteur du convertisseur à une démagnétisation complète de l'enroulement auxiliaire. En détectant la fin de démagnétisation, on s'assurerait que le convertisseur n'est plus dans un fonctionnement en mode continu (non démagnétisé à chaque cycle). Le contrôle de la tension auxiliaire, c'est-à-dire du point de démagnétisation, garantit le contrôle du courant dans l'interrupteur de découpage. On peut alors diminuer la fréquence du circuit 10, ce qui entraîne que les pics de courant sont moins nombreux. De plus, on supprime le problème de passage en mode continu dans la mesure où le convertisseur est maintenu dans un mode discontinu.

Toutefois, une telle solution requiert de pouvoir mesurer la tension auxiliaire. Or, lorsque l'interrupteur de découpage et son circuit de commande sont intégrés, comme c'est le cas dans un circuit VIPER, on ne dispose pas de borne d'accès à cette tension auxiliaire.

Un autre inconvénient est qu'en interdisant un fonctionnement en mode continu, on s'interdit la réalisation d'un convertisseur bitension (220 ou 110 volts). En effet, dans les convertisseurs bitension, on prévoit généralement un mode de fonctionnement discontinu pour 220 volts et un mode de fonctionnement continu pour 110 volts.

Ainsi, l'invention vise également à proposer une solution qui soit compatible avec une intégration du circuit de commande de l'interrupteur de découpage, plus particulièrement, avec un circuit intégré de type VIPER et le nombre de bornes correspondant. L'invention vise également à proposer une solution qui permette un fonctionnement en mode continu du convertisseur.

Plus particulièrement, la présente invention prévoit un circuit de commande d'un interrupteur de découpage d'une tension d'alimentation d'un enroulement primaire d'un transformateur de convertisseur de puissance, comportant des moyens pour détecter le courant dans l'interrupteur à l'état fermé après un temps prédéterminé qui suit chaque fermeture dudit interrupteur de découpage, et un comparateur de ce courant par rapport à un seuil, le résultat dudit comparateur étant pris en compte pendant une durée prédéterminée au voisinage du début d'un cycle de fermeture dudit interrupteur de découpage.

Selon un mode de réalisation de la présente invention, ledit résultat est pris en compte avec un retard prédéterminé par rapport à l'instant de fermeture de l'interrupteur de découpage.

Selon un mode de réalisation de la présente invention, le circuit comporte des moyens pour modifier une fréquence de découpage de la tension d'alimentation en fonction du résultat fourni par ledit comparateur.

Selon un mode de réalisation de la présente invention, le circuit est intégré avec l'interrupteur de découpage.

Selon un mode de réalisation de la présente invention, ledit seuil de courant est choisi pour autoriser ou non le fonctionnement du convertisseur en mode continu.

L'invention prévoit également un convertisseur de tension comprenant un circuit de commande d'un interrupteur de fourniture de courant à un enroulement primaire d'un transformateur à points de phase inversés dont un enroulement est associé à un condensateur de fourniture d'une tension continue de sortie régulée.

Selon un mode de réalisation de la présente invention, une borne d'entrée du circuit de commande destiné à fixer la fréquence d'oscillation est reliée à une tension d'alimentation par une résistance dont la valeur est choisie en fonction d'une fréquence de découpage minimal souhaitée.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1, 2, 3A, 3B et 3C qui ont été décrites précédemment sont destinées à exposer l'état de la technique et le problème posé ;
la figure 4 représente, sous forme de blocs, un mode de réalisation d'un circuit intégré d'un convertisseur de puissance selon la présente invention ; et
les figures 5A, 5B, 5C, 5D, 5E et 5F et 6 illustrent, sous forme de chronogrammes, le fonctionnement d'un circuit de commande selon l'invention.

Les mêmes éléments ont été désignés par les mêmes références aux différentes figures. Les figures 2, 3A à 3C, 5A à 5F et 6 ne sont pas l'échelle. Par souci de clarté, seuls les éléments du convertisseur qui sont nécessaires à la compréhension de l'invention ont été représentés aux figures et seront décrits par la suite. En particulier, la structure interne d'un circuit intégré de type VIPER n'a été détaillée que pour les éléments utiles à l'exposé de l'invention. Le reste de sa structure de même que le fonctionnement d'un tel circuit est connu.

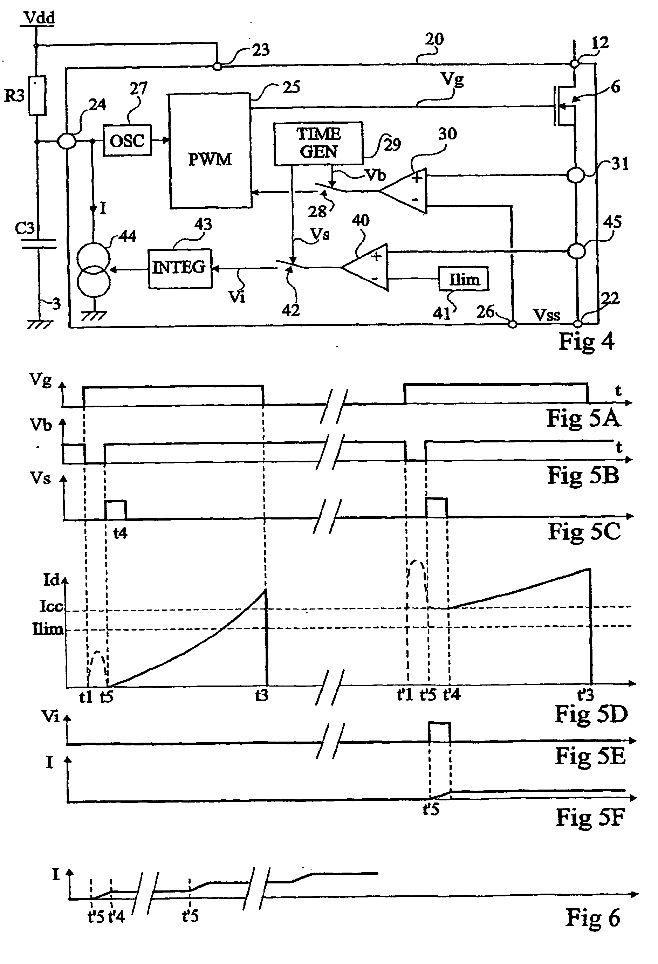

La figure 4 représente un mode de réalisation d'un circuit de commande d'un interrupteur de découpage d'une tension d'alimentation selon la présente invention. L'exemple de la figure 4 concerne le cas d'un circuit 20 intégrant l'interrupteur 6 de découpage (par exemple, un transistor MOS à canal N). Il s'agit d'un circuit reprenant, par exemple, les composants intégrés dans un circuit VIPER connu.

Comme précédemment, et bien que cela ne soit pas représenté en figure 4, un circuit selon l'invention fait partie d'un convertisseur recevant, en entrée, une tension redressée et filtrée. Cette tension est obtenue, par exemple, par redressement et filtrage d'une tension d'alimentation alternative. Toutefois, la tension d'entrée peut en variante provenir de n'importe quelle source d'alimentation, y compris une source continue.

De façon classique, l'interrupteur 6 est connecté en série avec un enroulement primaire (5, figure 1) d'un transformateur d'isolement entre les bornes d'application de la tension d'entrée. L'interrupteur 6 est commandé en modulation de largeur d'impulsions à fréquence relativement élevée (par exemple, plusieurs dizaines de kilohertz). Une borne 12 du circuit intégré 20 correspond au drain du transistor 6 et est destinée à être reliée au point de phase de l'enroulement primaire. Une borne 22 du circuit 20 correspond à une borne de référence de tension Vss, destinée à être reliée au potentiel de référence de la tension d'entrée (borne 3, figure 1). Le circuit 20 est alimenté par une basse tension continue Vdd. Cette tension est, comme précédemment, récupérée aux bornes d'un enroulement auxiliaire (8, figure 1) du transformateur. L'enroulement auxiliaire est, dans la mise en oeuvre de l'invention, en relation de phase directe avec un enroulement secondaire du transformateur qui délivre la tension continue régulée de sortie. Les moyens utilisés pour récupérer la tension Vdd sont, par exemple, constitués du condensateur C4 et de la diode D2 représentés en figure 1.

La tension d'alimentation locale Vdd est également fournie à une borne 23 du circuit 20. Elle alimente en outre une association en série d'une résistance R3 avec un condensateur C3 dont le point milieu est relié à une borne 24 servant à fixer la fréquence d'oscillation du circuit 20.

L'interrupteur 6 est commandé par un signal Vg appliqué sur la grille du transistor MOS. Ce signal Vg est fourni par un circuit 25 (PWM) classique chargé de modifier la largeur des impulsions de commande du transistor 6 pour réguler la tension de sortie du convertisseur. En pratique, le circuit 25 comprend, entre autres, un comparateur recevant en entrée une tension de référence intégrée et la tension d'alimentation Vdd (ou une tension proportionnelle à cette dernière). Ce comparateur est associé en sortie à une source de courant commandée en fonction du signal présent sur une borne 26 du circuit 20. La borne 26 est par exemple connectée, comme en figure 1, à la masse 3 par une résistance R5 en série avec un condensateur C5 qui participent à la boucle de régulation. La borne 26 correspond, en interne, à la sortie d'un amplificateur d'erreur de la boucle de régulation. Le circuit 25 reçoit en outre une fréquence d'oscillation d'un bloc OSC 27 dont l'entrée est reliée à la borne 24. Les détails constitutifs du circuit 25 n'ont pas été représentés et ne font pas l'objet de l'invention.

Pour remplir la fonction de limitation du courant dans l'interrupteur 6 à l'état fermé, le circuit 20 comporte un comparateur 30 dont une entrée non inverseuse est reliée à un élément 31 de mesure du courant dans l'interrupteur 6 et dont l'entrée inverseuse est reliée à la borne 26. L'élément 31 mesure, par exemple, le courant de source du transistor 6 et le convertit en tension pour transmettre l'information au comparateur 30. Le niveau de tension de l'entrée inverseuse du comparateur 30 correspond au niveau de sortie de l'amplificateur d'erreur de la boucle de régulation qui est, par construction, limité à une tension maximale. En variante, la borne 26 peut être reliée à n'importe quelle référence de tension adaptée. Par exemple, dans le cas (non représenté) d'une régulation par mesure au secondaire, la borne 26 est reliée au transistor d'un optocoupleur (ou équivalent) pour fournir une consigne de courant.

La sortie du comparateur 30 est reliée au bloc 25 par un interrupteur 28 commandé par un circuit 29 (TIME GEN) dont le rôle est de synchroniser l'ouverture de l'interrupteur 28 avec le début de chaque cycle de fermeture de l'interrupteur 6. Cela permet d'éviter des détections erronées de pics de courant lors de la fermeture.

Une caractéristique de la présente invention est d'utiliser le résultat d'une comparaison du courant dans l'interrupteur 6 par rapport à un courant de référence pour modifier, si besoin, la fréquence de découpage de la tension d'alimentation. Pour ce faire, le circuit 20 comporte un deuxième comparateur 40 dont une première entrée reçoit une information fonction du courant dans l'interrupteur 6 et dont une deuxième entrée reçoit une consigne liée à un courant limite (bloc 41, Ilim). De préférence, la consigne correspond à une référence fixe. La première entrée du comparateur 40 est, par exemple, reliée à un élément 45 de mesure du courant de source dans le transistor 6 ou exploite le résultat de l'élément 31. La sortie du comparateur 40 est reliée, par un interrupteur 42, à un intégrateur 43 dont la sortie commande une source de courant 44 connectée entre la borne 24 et la masse. Le rôle de l'intégrateur est d'accumuler le résultat de la comparaison entre deux périodes de mesure fixées par la fréquence de fermeture d'un interrupteur 42. L'interrupteur 42 est commandé par le circuit 29 qui fixe un retard par rapport à la fermeture de l'interrupteur 6 pour provoquer la fermeture de l'interrupteur 42 et, par ailleurs, détermine la durée de fermeture de l'interrupteur 42.

Les figures 5A, 5B, 5C, 5D, 5E et 5F illustrent, sous forme de chronogrammes, le fonctionnement d'un convertisseur de puissance selon l'invention et plus précisément de son circuit de commande. La figure 5A représente un exemple d'allure du signal Vg de commande de la grille du transistor 6. La figure 5B représente un exemple d'allure du signal Vb de commande de l'interrupteur 28. La figure 5C représente un exemple d'allure du signal Vs de commande de l'interrupteur 42. La figure 5D représente un exemple de courant Id dans l'interrupteur 6. La figure 5E représente la tension Vi en entrée de l'intégrateur 43. La figure 5F représente le courant I fixé par la source 44. Les chronogrammes des figures 5 représentent, en partie gauche, un cycle de fonctionnement normal, et, en partie droite, un cycle en cas de court-circuit.

On suppose une fermeture de l'interrupteur 6 à un instant t1 (figure 5B). Après un pic de courant (instants t1 à t5) lié à la commutation, le courant Id croît progressivement au fur et à mesure de la magnétisation de l'enroulement primaire du transformateur jusqu'à l'ouverture du commutateur 6 (instants t3). La durée d'une impulsion de fermeture de l'interrupteur 6 (instants t1 à t3, figure 5A) est généralement de quelques microsecondes (fréquence de découpage supérieure au kilohertz).

Le signal Vb de commande de l'interrupteur 28 est normalement à l'état haut, c'est-à-dire que l'interrupteur 28 est dans un état normalement fermé. Le circuit 29 provoque son ouverture pendant une courte durée (quelques centaines de nanosecondes) après chaque fermeture de l'interrupteur 6. La durée de l'impulsion à l'état bas du signal Vb, pendant laquelle le circuit de commande ne prend pas en compte le résultat de comparaison du comparateur 30, est liée à la durée du pic de courant parasite du début du cycle de magnétisation. La non prise en compte de l'impulsion parasite a été illustrée en figure 5D par un tracé en pointillés du pic de courant au début du cycle. Dans l'exemple de la figure 5B, le signal Vb est à l'état bas entre les instants t1 et t5. L'interruption de la comparaison permet d'éviter d'activer les moyens de limitation du courant sous l'effet des perturbations parasites liées aux commutations.

L'interrupteur 42 est dans un état normalement ouvert, c'est-à-dire que le signal Vs active la fermeture à l'état haut. Ainsi, le résultat de la comparaison fourni par le comparateur 40 n'est pris en compte et intégré par le circuit 43 que pendant une courte période à chaque cycle de fermeture de l'interrupteur 6. Le but est de comparer le courant du transistor 6 par rapport au courant limite au début de chaque cycle de fermeture. On doit toutefois éviter la prise en compte des pics parasites. Par conséquent, la fermeture de l'interrupteur 42 intervient à l'instant t5 où le pic a disparu. Par exemple, cette fermeture est simultanée avec la fermeture de l'interrupteur 28. La durée de la fermeture du signal Vs est choisie pour être courte devant la durée de fermeture de l'interrupteur 6. Par exemple, une durée de l'ordre de quelques centaines de nanosecondes (instants t5 à t4, figure 5C) permet de prendre en compte le courant au début du cycle de magnétisation.

Le résultat fourni par le comparateur 40, plus précisément en entrée de l'intégrateur 43, est illustré par la figure 5E. En fonctionnement normal, le courant croît depuis l'origine c'est-à-dire qu'on est dans le cas d'une démagnétisation complète à chaque cycle. Par conséquent, le résultat de la comparaison n'indique pas de dépassement du seuil du courant limite. Le courant I dans la source 44 n'est alors pas modifié.

En cas de court-circuit (partie droite des figures 5), les mêmes intervalles de temps sont présents. Ils sont identifiés par les mêmes références qu'en partie gauche des chronogrammes, affectées d'une apostrophe ('). Comme le secondaire est en court-circuit, la démagnétisation n'est pas complète. Il en découle qu'après un pic de courant (instants t'1 à t'5) important, la croissance du courant dans l'enroulement primaire du transformateur ne débute pas à zéro mais à une valeur Icc de court-circuit. Si cette valeur est supérieure au courant Ilim, le résultat fourni par le comparateur 40 est positif et l'intégrateur 43 modifie la commande de la source de courant 44. Il en résulte une augmentation du courant I à partir de l'instant t'5. Cette croissance est progressive sous l'effet de l'intégration de l'impulsion (instants t'5 à t'4) effectuée par l'intégrateur 43. A partir de l'instant t'4, le courant I est constant jusqu'au cycle suivant.

La figure 6 illustre, avec une échelle différente, trois cycles successifs où le secondaire du transformateur reste en court-circuit. Le courant I croît par paliers jusqu'au courant maximum de la source 44, fixé par construction.

L'augmentation du courant I prélevé sur la borne 24 a pour effet de diminuer la fréquence fournie par le bloc 27. Par conséquent, on diminue la fréquence de découpage de l'interrupteur 6, ce qui permet d'atteindre de nouveau une démagnétisation complète de celui-ci.

L'exemple représenté par la partie droite des chronogrammes des figures 5 ne correspond pas au cycle où se produit le court-circuit. En effet, quelques cycles sont nécessaires pour que l'absence de démagnétisation du transformateur le fasse passer en mode continu.

Le choix de la valeur prédéterminée Ilim du courant au-delà duquel on considère une absence de démagnétisation dépend de l'application et, notamment, si l'on souhaite autoriser ou non un mode de fonctionnement continu pour le transformateur.

En choisissant un courant Ilim suffisamment bas, on interdit le passage en mode continu. En effet, la source de courant 44 sera activée dès que le courant dans l'interrupteur 6 ne partira pas de l'origine. Le seuil choisi dépend toutefois alors de la durée de l'impulsion de détection.

Selon un mode de réalisation préféré de l'invention, on autorise le passage dans un mode continu du transformateur tout en limitant le courant dans celui-ci. Cela revient à autoriser le mode continu jusqu'à un certain seuil. Dans ce cas, la valeur du courant Ilim est, de préférence, comprise entre un quart et trois quarts (par exemple, la moitié) du courant maximal souhaité pour le transformateur.

Un avantage de préserver un fonctionnement en mode continu est que le convertisseur peut alors servir dans des applications bitension.

Un avantage de la présente invention est que la solution proposée est entièrement intégrable sans nécessiter de borne supplémentaire par rapport à un circuit intégré VIPER classique.

Un autre avantage de la présente invention est que même en fonctionnement normal, c'est-à-dire tant que la valeur maximale Imax du courant fixée par le comparateur 30 n'est pas atteinte, on protège déjà le transformateur grâce au choix d'une valeur de limitation Ilim inférieure à cette valeur maximale.

On peut adapter l'influence de la source de courant 44 sur la fréquence d'oscillation en modifiant la valeur de la résistance R3. En choisissant une résistance R3 relativement faible, on garantit une oscillation même lorsque la source de courant 44 a atteint son courant maximal. En choisissant une résistance R3 relativement grande, l'oscillation peut s'arrêter, par exemple, quand la valeur du courant I a atteint le maximum que peut délivrer la source.

Un avantage de l'invention est donc que l'on peut fixer une fréquence minimale de découpage.

Un autre avantage est qu'on améliore alors le démarrage du convertisseur de puissance. En effet, au démarrage du circuit, le condensateur (C2, figure 1) du secondaire du transformateur est entièrement déchargé. Le convertisseur se comporte alors temporairement comme un court-circuit. La mise en oeuvre de l'invention permet de limiter le courant pendant les premières millisecondes de fonctionnement du convertisseur.

Bien entendu, la présente invention est susceptible de diverses variantes et modifications qui apparaîtront à l'homme de l'art. En particulier, la réalisation pratique des fonctions de comparaison, d'intégration et de source de courant sont à la portée de l'homme du métier à partir des indications fonctionnelles données ci-dessus. De plus, les choix des seuils à appliquer et des valeurs des composants dépendent de l'application et de l'autorisation ou non du mode de fonctionnement continu, et seront donc adaptés par l'homme du métier.

## Revendications

1. Circuit (20) de commande d'un interrupteur (6) de découpage d'une tension d'alimentation d'un enroulement primaire d'un transformateur de convertisseur de puissance, **caractérisé en ce qu'**il comporte :
des moyens (45) pour détecter le courant dans l'interrupteur à l'état fermé après un temps prédéterminé qui suit chaque fermeture audit interrupteur de découpage ;
un premier comparateur (30) de limitation du courant détecté ; et
un deuxième comparateur (40) de ce courant par rapport à un seuil (Ilim), le résultat dudit deuxième comparateur étant pris en compte pendant une durée prédéterminée au voisinage du début d'un cycle de fermeture dudit interrupteur de découpage.

2. Circuit de commande selon la revendication 1, **caractérisé en ce que** ledit résultat est pris en compte avec un retard prédéterminé par rapport à l'instant de fermeture de l'interrupteur de découpage (6).

3. Circuit selon la revendication 1 ou 2, **caractérisé en ce qu'**il comporte des moyens (43, 44) pour modifier une fréquence de découpage de la tension d'alimentation en fonction du résultat fourni par ledit deuxième comparateur (40).

4. Circuit selon l'une quelconque des revendications 1 à 3, **caractérisé en ce qu'**il est intégré avec l'interrupteur de découpage (6).

5. Circuit selon l'une quelconque des revendications 1 à 4, **caractérisé en ce que** ledit seuil de courant (Ilim) est choisi pour autoriser ou non le fonctionnement du convertisseur en mode continu.

6. Convertisseur de tension comprenant un circuit de commande (20) d'un interrupteur (6) de fourniture de courant à un enroulement primaire (5) d'un transformateur (4) à points de phase inversés dont un enroulement (7) est associé à un condensateur (C2) de fourniture d'une tension continue de sortie régulée, **caractérisé en ce que** ledit circuit de commande est conforme à une quelconque des revendications 1 à 5.

7. convertisseur selon la revendication 6, **caractérisé en ce qu'**une borne (24) d'entrée du circuit de commande destinée à fixer la fréquence d'oscillation est reliée à une tension d'alimentation (Vdd) par une résistance (R3) dont la valeur est choisie en fonction d'une fréquence de découpage minimal souhaitée.

## Patentansprüche

1. Schaltung (20) zum Steuern eines Schalters (6) für eine geschaltete Versorgungsspannung einer primären Wicklung eines Leistungskonvertertransformators, **dadurch gekennzeichnet, dass** die Schaltung Folgendes aufweist:
Mittel (45) zum Detektieren des Stroms in dem Schalter im dem Ein-Zustand nach einer vorbestimmten Zeit, die dem Ein-Schalten des Schalters folgt;
einen ersten Komparator (30) zum Limitieren des detektierten Stroms; und
einen zweiten Komparator (40) für den Strom bezüglich eines Schwellenwerts (Ilim), wobei das Ergebnis des zweiten Komparators in Betracht gezogen wird für eine vorbestimmte Dauer in der Nähe des Beginns eines Ein-Zyklus des Schalters.

2. Steuerschaltung nach Anspruch 1 **dadurch gekennzeichnet, dass** das Ergebnis mit einer vorbestimmten Verzögerung bezüglich der Einschaltzeit des Schalters (6) in Betracht gezogen wird.

3. Schaltung nach Anspruch 1 oder 2 **dadurch gekennzeichnet, dass** es Mittel (43,44) aufweist zum Modifizieren einer Frequenz der Versorgungsspannung gemäß dem Ergebnis, das durch den zweiten Komparator (40) vorgesehen wird.

4. Schaltung nach einem der Ansprüche 1-3 **dadurch gekennzeichnet, dass** sie in dem Schalter (6) integriert ist.

5. Schaltung nach einem der Ansprüche 1-4 **dadurch gekennzeichnet, dass** der Stromschwellenwert (Ilim) so ausgewählt ist, dass er nicht den Betrieb des Wandlers in einem kontinuierlichen Modus erlaubt.

6. Spannungswandler, der eine Schaltung (20) aufweist zum Steuern eines Schalters (6) zum Vorsehen eines Stroms an eine Primärwicklung (5) eines Transformators (4) mit invertierten Phasenpunkten, dessen eine Wicklung (7) mit einem Kondensator (C2) assoziiert ist, zum Vorsehen einer regulierten Gleichspannungs-(DC)-Ausgangsspannung, **dadurch gekennzeichnet, dass** die Steuerschaltung eine nach einem der Ansprüche 1-5 ist.

7. Wandler nach Anspruch 6 **dadurch gekennzeichnet, dass** ein Eingabeterminal bzw. Anschluss (24) der Steuerschaltung, der vorgesehen ist zum Einstellen der Oscillationsspannung mit einer Versorgungsspannung (Vdd) über einen Widerstand (R3) verbunden ist, wobei der Wert gemäß einer gewünschten minimalen Schaltfrequenz ausgewählt wird

## Claims

1. A circuit (20) for controlling a switch (6) for a switched supply voltage of a primary winding of a power converter transformer, **characterized in that** it includes:
means (45) for detecting the current in the switch in the on state after a predetermined time that follows each turning-on of said switch;
a first comparator (30) for limiting the detected current; and
a second comparator (40) of said current with respect to a threshold (Ilim), the result of said second comparator being taken into account for a predetermined duration in the vicinity of the beginning of an on cycle of said switch.

2. The control circuit of claim 1, **characterized in that** said result is taken into account with a predetermined delay with respect to the turn-on time of the switch (6).

3. The circuit of claim 1 or 2, **characterized in that** it includes means (43, 44) for modifying a frequency of the supply voltage according to the result provided by said second comparator (40).

4. The circuit of any of claims 1 to 3, **characterized in that** it is integrated with the switch (6).

5. The circuit of any of claims 1 to 4, **characterized in that** said current threshold (Ilim) is chosen to allow or not the operation of the converter in continuous mode.

6. A voltage converter including a circuit (20) for controlling a switch (6) for providing current to a primary winding (5) of a transformer (4) with inverted phase points, a winding (7) of which is associated with a capacitor (C2) for providing a regulated D.C. output voltage, **characterized in that** said control circuit is that of any of claims 1 to 5.

7. The converter of claim 6, **characterized in that** an input terminal (24) of the control circuit intended for setting the oscillation voltage is connected to a supply voltage (Vdd) by a resistor (R3), the value of which is chosen according to a desired minimum switching frequency.
